(19) Europäisches Patentamt / European Patent Office / Office européen des brevets

(11) **EP 3 700 082 B1**

(12) **EUROPEAN PATENT SPECIFICATION**

(45) Date of publication and mention of the grant of the patent:
**15.06.2022 Bulletin 2022/24**

(21) Application number: **18868909.5**

(22) Date of filing: **29.08.2018**

(51) International Patent Classification (IPC):
*H02P 7/00* $^{(2016.01)}$   *H02P 29/50* $^{(2016.01)}$
*G01R 19/00* $^{(2006.01)}$   *H03G 3/30* $^{(2006.01)}$

(52) Cooperative Patent Classification (CPC):
**H02P 29/50; G01R 19/0092; H02P 7/0094;**
**H03F 1/26; H03F 3/45085; H03F 3/45475;**
**H03G 1/0023; H03G 3/30; H03G 3/345;**
G01R 19/0053; H03F 2200/372; H03F 2203/45392;
H03F 2203/45454; H03F 2203/45702

(86) International application number:
**PCT/JP2018/031944**

(87) International publication number:
**WO 2019/077889 (25.04.2019 Gazette 2019/17)**

(54) **NOISE REMOVAL CIRCUIT, NOISE REMOVAL METHOD, AND MOTOR CONTROL DEVICE**

RAUSCHUNTERDRÜCKUNGSSCHALTUNG, RAUSCHUNTERDRÜCKUNGSVERFAHREN UND MOTORSTEUERVORRICHTUNG

CIRCUIT ET PROCÉDÉ D'ÉLIMINATION DE BRUIT AINSI QUE DISPOSITIF DE COMMANDE DE MOTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.10.2017 JP 2017200793**

(43) Date of publication of application:
**26.08.2020 Bulletin 2020/35**

(73) Proprietor: **Mitsuba Corporation**
**Kiryu-shi, Gunma 376-8555 (JP)**

(72) Inventors:
• **YANAGITA, Yuichi**
  **Kiryu-shi, Gunma 376-8555 (JP)**

• **UCHIDA, Takuya**
  **Kiryu-shi, Gunma 376-8555 (JP)**

(74) Representative: **Hoffmann Eitle**
**Patent- und Rechtsanwälte PartmbB**
**Arabellastraße 30**
**81925 München (DE)**

(56) References cited:
**EP-A2- 0 405 593     JP-A- H06 244 745**
**JP-A- H10 123 053     JP-A- 2015 184 142**
**JP-U- H0 523 798**

## Description

### Technical Field

The present invention relates to a noise removal technique for electrical signals and, more particularly to a noise removal circuit and a noise removal method suitable for use in removal of spike-shaped noise contaminated in analog signals.

### Background Art

Conventionally, noise filters such as a low-pass filter are used for various types of analog signals, including a pulse signal, a communication signal, an audio signal and a control signal, to eliminate noise of spike-shaped sharp waveform (hereinafter referred to as spike noise) contaminated in such signals. For example, JP 2015-211636 A describes a brushed DC motor designed to remove current ripple signal noise using a low-pass filter at the time of, so-called, sensorless positioning.

Document EP 0 405 593 A2 describes a high-frequency signal measuring equipment with a variable gain pre-amplifier.

Disclosure of the Invention

Problems to be Solved by the Invention

However, the above-identified technique poses a problem in terms of removal of spike noise; for instance, if a filter equipped with an element having a time constant such as a capacitor is used, the original signal waveform may be blunted because of the time constant to change the waveform. Further, when passive noise removal elements such as a Zener diode or varistor are used, the signal waveform might be changed due to the capacitance components and/or nonlinear characteristics they possess. If a waveform is changed from the original signal by using such a filter, though removal of spike noise can be achieved, a waveform change from the original signal might lead to deterioration in the quality of waveform used in sensing, causing a reduction in sensing accuracy.

### Means for Solving the Problems

The object of the invention is achieved by the subject-matter of the independent claims. Advantageous embodiments are defined in the dependent claims. Further examples are provided for facilitating the understanding of the invention. A noise removal circuit according to an aspect is a noise removal circuit for removing spike-shaped noise from an electrical signal, which includes a signal amplifying section that receives the electrical signal and amplifies the electrical signal, and an amplification control section that controls the amplification factor of the signal amplifying section for the electrical signal according to the voltage of the electrical signal. The amplification control section puts a limit on the amplification factor of the signal amplifying section such that the amplification factor decreases as the voltage of the electrical signal increases.

In the present invention, when the voltage of an electrical signal is large, the amplification control section limits the amplification factor of the signal amplifying section. Therefore, when spike noise is contained in the electrical signal, the amplification factor is suppressed to a low level to reduce the amount of amplification at spike noise portions. As a result, the signal output from the signal amplifying section contains only a minimized level of spike noise and, hence, a signal from which the spike noise has been removed can be formed without deteriorating the original waveform.

In the noise removal circuit, the signal amplifying section has a differential amplifier circuit that amplifies the electrical signal and outputs the amplified signal, and the amplification control section has a signal converting section that converts a control signal formed based on the electrical signal into a current signal, and a current mirror circuit that changes a control current of the differential amplifier circuit based on the current signal received from the signal converting section to thereby control the amplification factor of the signal amplifying section. With this arrangement, the amplification control section can cause the current mirror circuit to control the control current to limit the amplification factor of the signal amplifying section so that the output of the differential amplifier circuit can be prevented from exceeding a predetermined value.

Further, in the noise removal circuit, there are arranged a control voltage generating circuit that extracts a center value of a ripple component from the electrical signal as a change component of the electrical signal and outputs the change component as an output signal, and a signal inverting circuit that vertically inverts the waveform of the output signal from the control voltage generating circuit. The aforementioned control signal is output from the signal inverting circuit to the signal converting section.

Furthermore, when it is anticipated that the voltage of the electrical signal will become equal to or greater than a predetermined value, the amplification control section may reduce the amplification factor of the signal amplifying section.

A noise removal method is a method for removing spike-shaped noise from an electrical signal. The method uses a differential amplifier circuit that amplifies an electrical signal and outputs the amplified signal, a signal converting section that converts a control signal formed based on the electrical signal into a current signal, and a current mirror circuit that changes a control current of the differential amplifier circuit based on the current signal received from the signal converting section to thereby control the amplification factor of the signal amplifying section. The current mirror circuit controls a control current of the differential amplifier circuit, limiting the amplification factor of the differential amplifier circuit in such a manner that the amplification factor of the signal amplifying section decreases as the voltage of the electrical signal increases so as to prevent the output of the differential amplifier circuit from exceeding a predetermined value and, whereby the noise is removed.

In the present invention, when the voltage of the electrical signal is large, the current mirror circuit puts a limit on the amplification factor of the differential amplifier circuit by changing the control current of the differential amplifier circuit. Such an arrangement allows the amplification factor to be suppressed to a low level when the electrical signal contains spike noise, and hence the amount of amplification at spike noise portions becomes small. As a result, the spike noise in the signal output from the differential amplifier circuit can be minimized, and in turn, a signal from which the spike noise has been removed can be formed without deteriorating the original waveform.

Further, a motor control device according to an aspect is a motor control device including a current detecting section that detects an armature current of a DC motor and outputs a change in the current as a voltage change signal, and a noise removal circuit that is provided in a stage subsequent to the current detecting section and removes spike-shaped noise contained in the armature current. The noise removal circuit includes a signal amplifying section that amplifies the voltage change signal, and an amplification control section to which a control signal formed based on the voltage change signal is input and that controls the amplification factor of the signal amplifying section for the voltage change signal, based on the voltage of the voltage change signal. The amplification control section puts a limit on the amplification factor of the signal amplifying section such that the amplification factor decreases as the voltage of the voltage change signal increases.

In the noise removal circuit according to an aspect, when the voltage of the voltage change signal is large, the amplification control section limits the amplification factor of the signal amplifying section. Therefore, the amplification factor is suppressed to a low level when spike noise is contained in the voltage change signal and hence the amount of amplification at spike noise portions is reduced. As a result, the spike noise in the signal output from the differential amplifier circuit can be minimized, and in turn, a signal from which the spike noise has been removed can be formed without deteriorating the original waveform.

In the motor control device, the signal amplifying section has a differential amplifier circuit that amplifies the voltage change signal and outputs the amplified signal, and the amplification control section has a signal converting section that converts the control signal into a current signal and a current mirror circuit that changes a control current of the differential amplifier circuit based on the current signal received from the signal converting section to thereby control the amplification factor of the signal amplifying section.

**Advantageous Effects of the Invention**

The noise removal circuit of the present invention includes a signal amplifying section that amplifies the voltage of an electrical signal and an amplification control section that controls the amplification factor of the signal amplifying section according to the voltage of the electrical signal, and a limitation is put so that the amplification factor of the signal amplifying section decreases as the voltage of the electrical signal increases.

Therefore, when spike noise is contained in the electrical signal, the amplification factor is suppressed to a low level to reduce the amount of amplification at spike noise portions. This arrangement allows the spike noise contained in the signal output from the signal amplifying section to be minimized, thus removing the spike noise without deteriorating the original waveform.

The noise removal method of the present invention uses a differential amplifier circuit that amplifies the voltage of an electrical signal, a signal converting section that converts a control signal formed based on the electrical signal into a current signal, and a current mirror circuit that changes a control current of the differential amplifier circuit based on the current signal received from the signal converting section to thereby control the amplification factor of the signal amplifying section. The current mirror circuit changes the control current of the differential amplifying circuit to limit the amplification factor of the differential amplifier circuit in such a manner that the amplification factor of the signal amplifying section decreases as the voltage of the electrical signal increases. Therefore, when the electrical signal contains spike noise, the amplification factor can be suppressed to a low level and hence the amount of amplification at spike noise portions can be small. This arrangement allows the spike noise contained in the signal output from the differential amplifier circuit to be minimized, thus enabling the removal of the spike noise without deteriorating the original waveform.

The motor control device of the present invention includes a current detecting section that detects an armature current of a DC motor and outputs a change in the current as a voltage change signal and a noise removal circuit that is provided in a stage subsequent to the current detecting section and removes spike-shaped noise contained in the armature current. The noise removal circuit includes a signal amplifying section that amplifies the voltage change signal and an amplification control section that controls the amplification factor of the signal amplifying section based on the voltage of the voltage change signal. The amplification factor of the signal amplifying section is limited such that it decreases as the voltage of the voltage change signal increases. This arrangement allows the amplification factor to be suppressed to a low level when spike noise is contained in the voltage change signal and hence the amount of amplification at spike noise portions can be reduced. The spike noise in the signal output from the signal amplifying section can therefore be minimized, and the spike noise can be removed without deteriorating the original waveform, which consequently improves motor control accuracy.

**Brief Description of the Drawings**

FIG. 1 is a block diagram showing the configuration of a noise removal circuit according to an embodiment of the present invention;
FIG. 2 is an exemplary output signal from a current detecting section;
FIG. 3 is an explanatory view illustrating how a control voltage generating circuit operates;
FIG. 4 is an explanatory view illustrating how a CV inverting circuit operates;
FIGS. 5A and 5B are explanatory views showing an effect of the noise removal circuit;
FIG. 6 is an explanatory view showing the internal structure of the noise removal circuit; and
FIGS. 7A and 7B are explanatory views showing an actual noise removal effect produced by the noise removal circuit.

**Best Mode for Carrying Out the Invention**

Hereinafter, an embodiment of the present invention will be described in detail based on the drawings. It is an object of the embodiment to be described below to provide a noise removal circuit and a noise removal method capable of removing spike noise contaminated in an electrical signal therefrom while keeping the shape of the original waveform as much as possible.

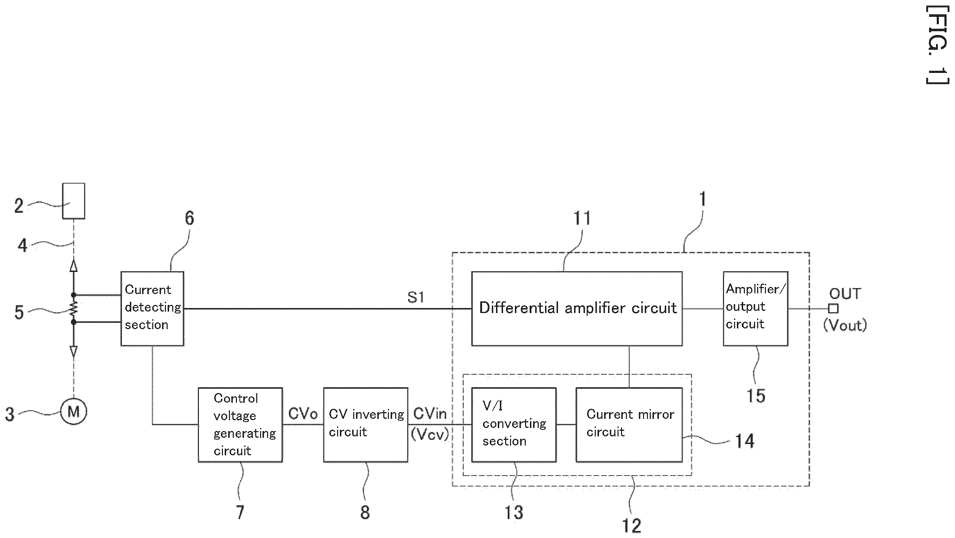

FIG. 1 is a block diagram showing the configuration of a noise removal circuit 1 according to an embodiment of the present invention, and the noise removal method according to the present invention is also implemented by way of the circuit 1. The noise removal circuit 1 may be used in, e.g., an operation control device for automotive power window motor, and designed to remove spike noise of motor current (armature current) while maintaining the original waveform. This makes it possible to extract a current ripple from the motor current by accurately converting the former into a digital signal and detect, e.g., the rotational speed or direction of rotation of DC motor without using a rotation detecting member such as a hall IC.

The noise removal circuit 1 is disposed on a power supply line 4 for supplying power from a power supply 2 to a brushed DC motor 3 (hereinafter abbreviated as motor 3). On the power supply line 4 is arranged a shunt resistor 5, and the noise removal circuit 1 is connected to back and forth positions of the shunt resistor 5 (the side of power supply 2 and the side of motor 3). In the stage that follows the noise removal circuit 1, a ripple detection device (not illustrated) is connected, which extracts only a ripple component from a current ripple signal from which spike noise has been eliminated and outputs the ripple component in the form of a square wave. The drive control device of motor 3 includes the noise removal circuit 1 and the aforementioned ripple detection device, and controls the operation of the motor 3 through the calculation of the rotational speed, direction of rotation and the like of the motor 3, based on the square wave output from the ripple detection device.

In the stage preceding the noise removal circuit 1, as illustrated in FIG. 1, between the noise removal circuit 1 and the shunt resistor 5 are provided a current detecting section (signal detecting section) 6, a control voltage (CV) generating circuit 7 and a CV inverting circuit (signal inverting circuit) 8. The noise removal circuit 1 is configured to receive a voltage change signal S1 from the current detecting section 6. The noise removal circuit 1 is also configured to receive a gain control signal CVin from the CV inverting circuit 8. The noise removal circuit 1 uses the gain control signal CVin to remove spike noise from the voltage change signal S1 and, thereupon, amplifies the resultant signal, which is then output as a waveform adjustment signal Vout. The configuration consisting of the noise removal circuit 1 and the control voltage generating circuit 7 and CV inverting circuit (signal inverting circuit) 8 located in stages preceding the noise removal circuit 1 can be considered as a noise removal circuit; additionally the current detecting section 6 may also be counted as one of the elements constituting the noise removal circuit.

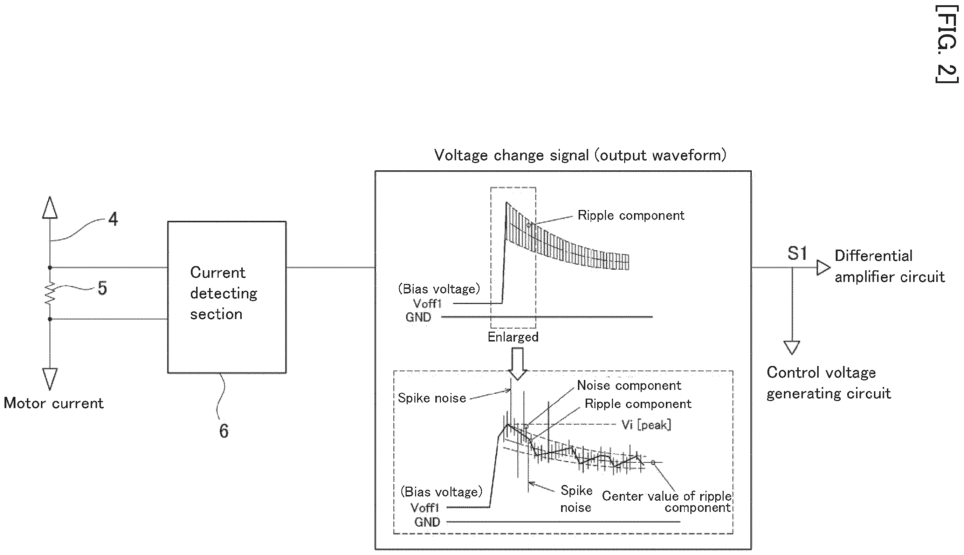

The current detecting section 6 detects a voltage difference (voltage drop) across the shunt resistor 5 and detects the voltage of motor drive current. The current detecting section 6 outputs a voltage change of the motor drive current as a voltage change signal (electrical signal) S1. FIG. 2 is an exemplary output signal from the current detecting section 6. At the current detecting section 6, the voltage difference across the shunt resistor 5 is subject to differential amplification with bias voltage Voff1 based on power supply voltage as a reference, and then output. As shown in FIG. 2, the voltage change signal S1 contains a noise component such as spike noise and a current ripple component. The current detecting section 6 outputs a voltage signal containing the noise and current ripple components to the noise removal circuit 1 and the control voltage generating circuit 7.

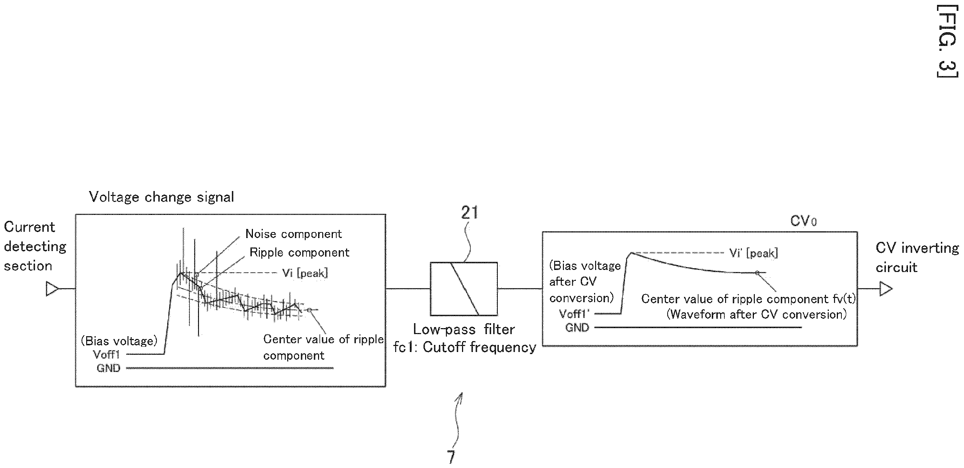

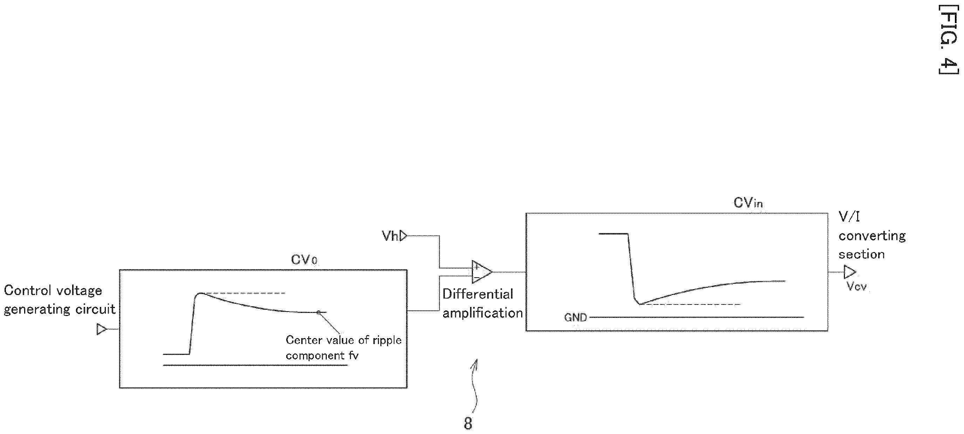

FIG. 3 is an explanatory view illustrating how the control voltage generating circuit 7 operates. FIG. 4 is an explanatory view illustrating how the CV inverting circuit 8 operates. The control voltage generating circuit 7 uses a low-pass filter 21 to extract a center value of the current ripple component as a motor drive current change component (fv(t) of FIG. 3) from the voltage change signal S1 (FIG. 2) received from the current detecting section 6, and outputs the change component as original control voltage $CV_0$. The original control voltage $CV_0$ is input to the CV inverting circuit 8, where, as shown in FIG. 4, the voltage signal is vertically inverted to produce a gain control signal CVin. The gain control signal CVin (of voltage Vcv) obtained by the vertical inversion of original control voltage $CV_0$ is then input to the noise removal circuit 1.

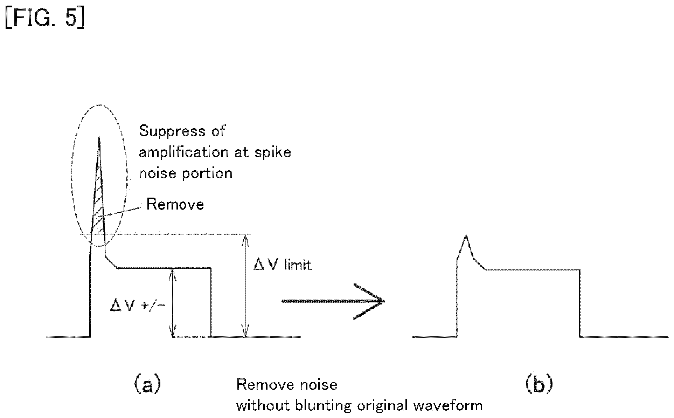

Here, as illustrated in FIG. 5, if the voltage change signal S1 is amplified without passing through the above processes to form a square wave signal, spike noise is also amplified to result in such a signal form as illustrated in FIG. 5A. In that case, if a filter or the like having a time constant is used as mentioned above, the spike noise can be removed but the signal waveform is blunted, which does not allow signal duration to be accurately grasped. In order to cope with the problem, the noise removal circuit 1 uses the gain control signal CVin obtained by inverting the original control voltage $CV_0$, controlling a variable gain amplifier circuit provided in the noise removal circuit 1 to remove the spike noise as well as maintain the original waveform.

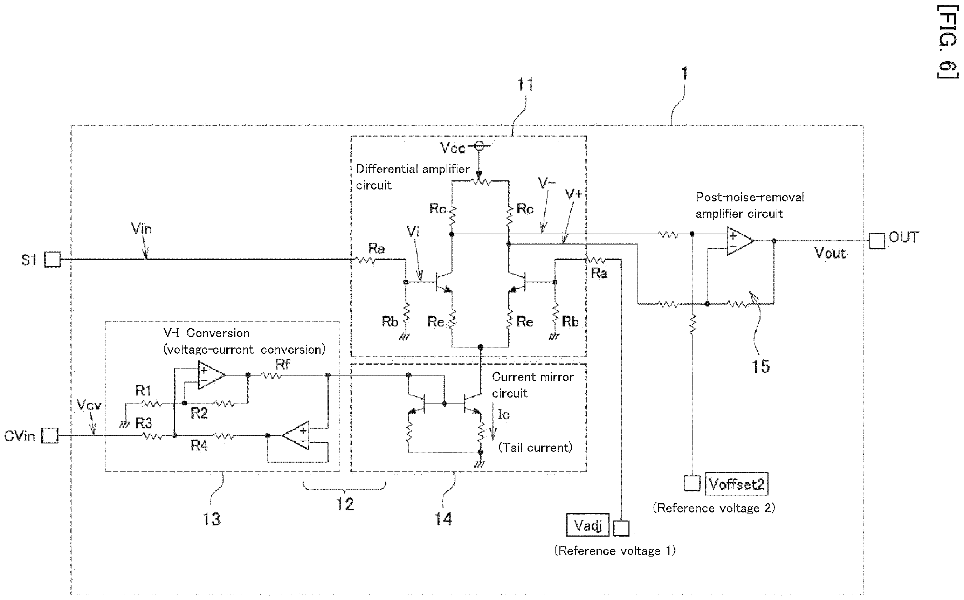

FIG. 6 is an explanatory view showing the internal structure of the noise removal circuit 1. As illustrated in FIGs. 1 and 6, the noise removal circuit 1 is constituted by a differential amplifier circuit section (signal amplifying section) 11 to which the voltage change signal S1 is input and an amplification control section 12 that controls the amplification factor (gain) of the differential amplifier circuit section 11. The differential amplifier circuit section 11 is a variable gain amplifier circuit whose amplification factor can be adjusted by the amplification control section 12 that controls the tail current (control current) flowing along the differential amplifier circuit. The amplification control section 12 includes a V/I converting section (signal converting section) 13 to which control voltage CVin is input and a current mirror circuit section 14. The amplification control section 12 controls the current input to the current mirror circuit section 14 so as to adjust the gain of the differential amplifier circuit section 11. The noise removal circuit 1 further includes an amplifier/output circuit section 15 in the stage following the differential amplifier circuit section 11. The amplifier/output circuit section 15 amplifies a signal from which spike noise has been removed and outputs the thus amplified signal as a waveform adjustment signal Vout.

The gain control signal CVin input to the noise removal circuit 1 is converted into a current signal by the V/I converting section 13 and then input to the current mirror circuit section 14. The gain control signal CVin (Vcv) has a vertically inverted shape of original control voltage $CV_0$. In other words, when the original control voltage $CV_0$ is large, the gain control signal CVin is small, and when the former is small, the latter is large. Thus, the current value input to the current mirror circuit section 14 is smaller as the original control voltage $CV_0$ is larger, and the former is larger as the latter is smaller. Therefore, the tail current Ic (see FIG. 6) of the differential amplifier circuit section 11 will also increase or decrease in a similar way, and the gain of the differential amplifier circuit section 11 is suppressed to a low level as the original control voltage $CV_0$ increases, while the former increases as the latter decreases.

In the noise removal circuit 1, when an amount of noise that exceeds a predetermined level is to be removed from the signal shown in FIG. 5A, the relationship between the threshold value of noise level ($\Delta V$ limit shown in FIG. 5: a predetermined value) and tail current Ic for controlling the noise level (Ic limit, see FIG. 6) are approximated as expressed below:

$$\Delta V \text{ limit} = (\text{Ic limit}/2) \times \text{Rc} \ .... \ (1)$$

(Rc: Resistance of the power supply (Vcc) side at the differential amplifier circuit section 11; see FIG. 6.).

In order to avoid adverse influence on the original signal, $\Delta V$ limit is preferably adjusted to establish a relationship with $\Delta V$+/- as $\Delta V$ limit > $\Delta V$+/-.

On the other hand, the tail current Ic has the same value as the current signal obtained by converting the gain control signal CVin (Vcv) at the V/I converting section 13 (effect of the current mirror circuit section 14), and is expressed as follows:

$$Ic\ limit = Vcv/Rf \quad .... \quad (2)$$

(Rf: Resistance in the V/I converting section 13 in the stage preceding the current mirror circuit section; see FIG. 6) .

The $\Delta V$ limit can be expressed based on the above expressions (1) and (2), as follows:

$$\Delta V\ limit = Vcv \times Rc/(2Rf)$$

Hence, the $\Delta V$ limit changes according to Vcv, and when Vcv is small (where spike noise is contained, voltage of the voltage change signal S1 is large, and the original control voltage $CV_0$ increases), the $\Delta V$ limit decreases and the gain is suppressed. That is, in the noise removal circuit 1, the Ic limit functions to limit the amplification factor of the differential amplifier circuit section 11, preventing the output of the differential amplifier circuit section 11 from exceeding the $\Delta V$ limit. In this case, the $\Delta V$ limit is controlled so as to be smaller as the original control voltage $CV_0$ is larger. As a result, the gain is reduced only at the spike noise portions in the voltage change signal S1, and a square wave signal having such a waveform as shown in FIG. 5B is produced, removing the spike noise as well as maintaining the original waveform.

As illustrated in FIG. 3, in the voltage change signal S1, as noise increases, the original control voltage $CV_0$ (fv(t) of FIG. 3) that is the result of extraction of the center value of current ripple component also increases and, in addition, the spike noise tends to appear more significantly as the current value is larger. According to the above trend, when such a voltage change signal S1 is input to the noise removal circuit 1, the gain is suppressed as the original control voltage $CV_0$ increases, that is, as noise increases with a large amount of spike noise. On the other hand, the gain increases as the original control voltage $CV_0$ decreases, that is, as noise decreases. Thus, spike noise is minimized in the signal to be output from the noise removal circuit 1, so that a waveform adjustment signal Vout with a waveform from which spike noise has removed is output.

With the noise removal circuit 1 according to the present invention, as described above, the current mirror circuit that is typically used with a constant current in most cases is actively used, limiting the amount of tail current Ic of the differential amplifier circuit section 11 and controlling the gain of the differential amplifier circuit section 11. To the current mirror circuit section 14, an inversion signal of original control voltage $CV_0$ extracted from the voltage change signal S1 to be controlled is input as a gain control signal CVin. With this arrangement, the tail current Ic changes according to the voltage change signal S1 and the gain of the differential amplifier circuit section 11 is thus controlled. Then, if spike noise is contained in the voltage change signal S1, the tail current Ic is reduced to limit the amplification factor.

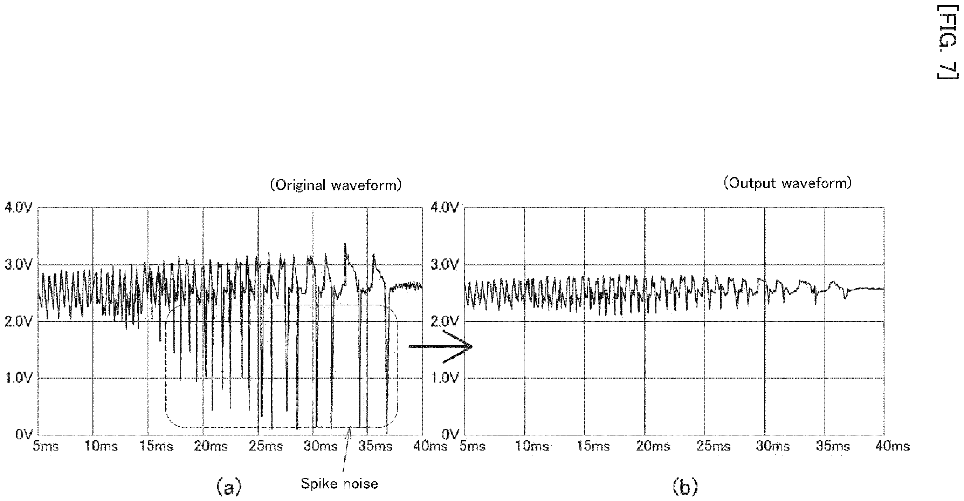

As a result, when spike noise is contained, the gain where the spike noise appears is suppressed and the amount of amplification at the spike noise portions becomes small. On the other hand, the amount of amplification at portions where no spike noise occurs is maintained at a level, resulting in such a signal waveform as illustrated in FIG. 5B, where spike noise has been removed. FIG. 7 is an explanatory view showing an actual noise removal effect produced when the noise removal circuit 1 is used. As FIG. 7B shows, the noise removal circuit 1 can remove the spike noise contained in the waveform shown in FIG. 7A without deteriorating said waveform. Hence, the use of the noise removal circuit 1 of the present invention makes it possible to remove the spike noise contained in the voltage change signal S1, an electrical signal, while maintaining the original waveform as much as possible, preventing waveform deterioration. This allows a current ripple from being extracted, through accurate digitization thereof, from the motor current, making it possible to improve motor control accuracy.

For example, while an inversion signal of original control voltage $CV_0$ is used as a gain control signal CVin in the above embodiment, the original control voltage $CV_0$ itself can be used. In that case, for example, output of the V/I converting section 13 is inverted, or the operation of the differential amplifier circuit section 11 for the tail current Ic is carried out in an inverse manner so that the gain of the differential amplifier circuit section 11 decreases as the original control voltage $CV_0$ increases.

Further, while the tail current Ic is changed in response to variations in the gain control signal CVin in the above embodiment, the tail current Ic may be controlled by anticipating the decrease or increase from the change in the gain control signal CVin. In other words, if the presence of spike noise is predicted, the tail current Ic may be actively controlled to remove the spike noise. For example, if the gain control signal CVin shows a predetermined value or higher than that, or a variation in the gain control signal CVin in microtime exceeds a certain threshold (such as when the derivative of CVin becomes equal to or higher than a predetermined value), it can be determined that spike noise will highly possibly occur, and the tail current Ic is therefore reduced using a prediction control unit separately provided in the amplification control section 12.

**Industrial Applicability**

The noise removal circuit and the noise removal method according to the present invention can find widespread applications, not only in motor operation control but also removal of spike noise contained in electrical signals. The present invention is applicable not only to the operation control of power window motor as described in the above embodiment but also automotive electrical equipment including, for example, windscreen wipers and power seats, domestic electrical appliances using a brushed motor, etc.

**Reference signs list**

1: Noise removal circuit
2: Power supply
3: Brushed DC motor
4: Power supply line
5: Shunt resistor
6: Current detecting section
7: Control voltage generating circuit
8: CV inverting circuit
11: Differential amplifier circuit section
12: Amplification control section
13: V/I converting section
14: Current mirror circuit section
15: Amplifier/output circuit section
21: Low-pass filter
$CV_0$: Original control voltage
CVin: Gain control signal
Ic: Tail current
S1: Voltage change signal
Vcv: Gain control signal voltage
Vout: Waveform adjustment signal

**Claims**

1.  A noise removal circuit (1) for removing spike-shaped noise from an electrical signal, comprising:

    a signal amplifying section (11) that is configured to receive the electrical signal and amplify the electrical signal; and
    an amplification control section (12) that is configured to control the amplification factor of the signal amplifying section for the electrical signal according to the voltage of the electrical signal,
    wherein the amplification control section puts a limit on the amplification factor of the signal amplifying section such that the amplification factor decreases as the voltage of the electrical signal increases;
    wherein
    the signal amplifying section has a differential amplifier circuit (11) configured to amplify the electrical signal and output the amplified signal;
    **characterised in that**
    the amplification control section has a signal converting section (13) configured to convert a control signal formed based on the electrical signal into a current signal, and a current mirror circuit (14) configured to change a control current of the differential amplifier circuit based on the current signal received from the signal converting section to thereby control the amplification factor of the signal amplifying section,
    wherein the amplification control section uses the current mirror circuit to control the control current, limiting the amplification factor of the signal amplifying section, in order to prevent the output of the differential amplifier circuit from exceeding a predetermined value;
    and further **characterised in that** the noise removal circuit (1) comprises:

    a control voltage generating circuit (7) configured to extract a center value of a ripple component from the electrical signal as a change component of the electrical signal and output the change component as an output signal; and

a signal inverting circuit (8) configured to vertically invert the waveform of the output signal from the control voltage generating circuit and output the resulting signal,

wherein the control signal is output from the signal inverting circuit and input to the signal converting section.

2. The noise removal circuit according to Claim 1, wherein when the voltage of the electrical signal is predicted to become equal to or greater than a predetermined value, the amplification control section reduces the amplification factor of the signal amplifying section.

3. A noise removal method for removing spike-shaped noise from an electrical signal, comprising: a differential amplifier circuit (11) that amplifies an electrical signal and outputs the amplified signal;

a signal converting section (13) that converts a control signal formed based on the electrical signal into a current signal; and

a current mirror circuit (14) that changes a control current of the differential amplifier circuit based on the current signal received from the signal converting section to thereby control the amplification factor of the signal amplifying section,

wherein the current mirror circuit controls a control current of the differential amplifier circuit, limiting the amplification factor of the differential amplifier circuit in such a manner that the amplification factor of the signal amplifying section decreases as the voltage of the electrical signal increases so as to prevent the output of the differential amplifier circuit from exceeding a predetermined value;

a control voltage generating circuit (7) that extracts a center value of a ripple component from the electrical signal as a change component of the electrical signal and output the change component as an output signal; and

a signal inverting circuit (8) that vertically inverts the waveform of the output signal from the control voltage generating circuit and output the resulting signal,

wherein the control signal is output from the signal inverting circuit and input to the signal converting section.

4. A motor control device including a current detecting section that detects an armature current of a DC motor and outputs a change in the current as a voltage change signal, and the noise removal circuit of claims 1 or 2, wherein the noise removal circuit is arranged at a stage subsequent to the current detecting section and removes spike-shaped noise contained in the armature current.

**Patentansprüche**

1. Rauschunterdrückungsschaltung (1) zum Entfernen von spitzenförmigem Rauschen aus einem elektrischen Signal, umfassend:

einen Signalverstärkungsabschnitt (11), der konfiguriert ist, um das elektrische Signal zu empfangen und das elektrische Signal zu verstärken; und

einen Verstärkungssteuerabschnitt (12), der konfiguriert ist, um den Verstärkungsfaktor des Signalverstärkungsabschnitts für das elektrische Signal gemäß der Spannung des elektrischen Signals zu steuern,

wobei der Verstärkungssteuerabschnitt den Verstärkungsfaktor des Signalverstärkungsabschnitts derart begrenzt, dass der Verstärkungsfaktor abnimmt, wenn die Spannung des elektrischen Signals zunimmt; wobei

der Signalverstärkungsabschnitt eine Differenzverstärkerschaltung (11) aufweist, die konfiguriert ist, um das elektrische Signal zu verstärken und das verstärkte Signal auszugeben;

**dadurch gekennzeichnet, dass** der Verstärkungssteuerabschnitt einen Signalumwandlungsabschnitt (13) aufweist, der konfiguriert ist, um ein Steuersignal, das basierend auf dem elektrischen Signals gebildet wird, in ein Stromsignal umzuwandeln, und eine Stromspiegelschaltung (14), die konfiguriert ist, um einen Steuerstrom der Differenzverstärkerschaltung basierend auf dem von dem Signalumwandlungsabschnitt empfangenen Stromsignal zu ändern, um dadurch den Verstärkungsfaktor des Signalverstärkungsabschnitts zu steuern,

wobei der Verstärkungssteuerabschnitt die Stromspiegelschaltung verwendet, um den Steuerstrom zu steuern, wodurch der Verstärkungsfaktor des Signalverstärkungsabschnitts begrenzt wird, um zu verhindern, dass die Ausgabe der Differenzverstärkerschaltung einen vorbestimmten Wert überschreitet; und

weiter **dadurch gekennzeichnet ist, dass** die Rauschunterdrückungsschaltung (1) umfasst:

eine Steuerspannungserzeugungsschaltung (7), die konfiguriert ist, um einen Mittenwert einer Welligkeitskomponente aus dem elektrischen Signal als eine Änderungskomponente des elektrischen Signals zu extrahieren und die Änderungskomponente als ein Ausgangssignal auszugeben; und
eine Signalumkehrschaltung (8), die konfiguriert ist, um die Wellenform des Ausgangssignals von der Steuerspannungserzeugungsschaltung vertikal umzukehren und das resultierende Signal auszugeben,
wobei das Steuersignal von der Signalumkehrschaltung ausgeben und in den Signalumwandlungsabschnitt eingegeben wird.

**2.** Rauschunterdrückungsschaltung nach Anspruch 1,
wobei, wenn vorhergesagt wird, dass die Spannung des elektrischen Signals gleich oder größer als ein vorbestimmter Wert wird, der Verstärkungssteuerabschnitt den Verstärkungsfaktor des Signalverstärkungsabschnitts verringert.

**3.** Rauschunterdrückungsverfahren zum Entfernen von spitzenförmigem Rauschen aus einem elektrischen Signal, umfassend:

eine Differenzverstärkerschaltung (11), die ein elektrisches Signal verstärkt und das verstärkte Signal ausgibt;
einen Signalumwandlungsabschnitt (13), der ein Steuersignal, das basierend auf dem elektrischen Signal gebildet wird, in ein Stromsignal umwandelt; und
eine Stromspiegelschaltung (14), die einen Steuerstrom der Differenzverstärkerschaltung basierend auf dem von dem Signalumwandlungsabschnitt empfangenen Stromsignal ändert, um dadurch den Verstärkungsfaktor des Signalverstärkungsabschnitts zu steuern,
wobei die Stromspiegelschaltung einen Steuerstrom der Differenzverstärkerschaltung steuert, wodurch der Verstärkungsfaktor der Differenzverstärkerschaltung derart begrenzt wird, dass der Verstärkungsfaktor des Signalverstärkungsabschnitts abnimmt, wenn die Spannung des elektrischen Signals zunimmt, um zu verhindern, dass der Ausgang der Differenzverstärkerschaltung einen vorbestimmten Wert nicht überschreitet;
eine Steuerspannungserzeugungsschaltung (7), die einen Mittenwert einer Welligkeitskomponente aus dem elektrischen Signal als eine Änderungskomponente des elektrischen Signals extrahiert und die Änderungskomponente als ein Ausgangssignal ausgibt; und
eine Signalumkehrschaltung (8), welche die Wellenform des Ausgangssignals von der Steuerspannungserzeugungsschaltung vertikal umkehrt und das resultierende Signal ausgibt,
wobei das Steuersignal von der Signalumkehrschaltung ausgeben und in den Signalumwandlungsabschnitt eingegeben wird.

**4.** Motorsteuervorrichtung mit einem Stromerfassungsabschnitt, der einen Ankerstrom eines Gleichstrommotors erfasst und eine Änderung des Stroms als ein Spannungsänderungssignal ausgibt, und mit der Rauschunterdrückungsschaltung nach Anspruch 1 oder 2, wobei die Rauschunterdrückungsschaltung ist einer Stufe nach dem Stromerfassungsabschnitt angeordnet ist und im Ankerstrom enthaltenes spitzenförmiges Rauschen entfernt.

**Revendications**

**1.** Circuit d'élimination de bruit (1) pour éliminer un bruit en forme de pointe d'un signal électrique, comprenant :

une section d'amplification de signal (11) qui est configurée pour recevoir le signal électrique et amplifier le signal électrique ; et
une section de commande d'amplification (12) qui est configurée pour commander le facteur d'amplification de la section d'amplification de signal pour le signal électrique selon la tension du signal électrique,
dans lequel la section de commande d'amplification met une limite au facteur d'amplification de la section d'amplification de signal de telle sorte que le facteur d'amplification diminue lorsque la tension du signal électrique augmente ;
dans lequel
la section d'amplification de signal présente un circuit amplificateur différentiel (11) configuré pour amplifier le signal électrique et sortir le signal amplifié ;
**caractérisé en ce que** la section de commande d'amplification présente une section de conversion de signal (13) configurée pour convertir un signal de commande formé sur la base du signal électrique en un signal de courant, et un circuit miroir de courant (14) configuré pour changer un courant de commande du circuit amplificateur différentiel sur la base du signal de courant reçu de la section de conversion de signal pour commande ainsi le facteur d'amplification de la section d'amplification de signal,

dans lequel la section de commande d'amplification utilise le circuit miroir de courant pour commander le courant de commande, limitant le facteur d'amplification de la section d'amplification de signal, afin d'empêcher la sortie du circuit amplificateur différentiel de dépasser une valeur prédéterminée ; et

**caractérisé en outre en ce que** le circuit d'élimination de bruit (1) comprend :

un circuit de génération de tension de commande (7) configuré pour extraite une valeur centrale d'une composante d'ondulation du signal électrique en tant que composante de changement du signal électrique et sortir la composante de changement en tant que signal de sortie ; et

un circuit d'inversion de signal (8) configuré pour inverser verticalement la forme d'onde du signal de sortie provenant du circuit de génération de tension de commande et délivrer le signal résultat,

dans lequel le signal de commande est sorti du circuit d'inversion de signal et entré dans la section de conversion de signal.

2. Circuit d'élimination de bruit selon la revendication 1,

dans lequel, lorsque la tension du signal électrique est prévue pour devenir égale ou supérieure à une valeur prédéterminée, la section de commande d'amplification réduit le facteur d'amplification de la section d'amplification de signal.

3. Procédé d'élimination de bruit pour éliminer le bruit en forme de pointe d'un signal électrique, comprenant :

un circuit amplificateur différentiel (11) qui amplifie un signal électrique et sort le signal amplifié ;

une section de conversion de signal (13) qui convertit un signal de commande formé sur la base du signal électrique en un signal de courant ; et

un circuit miroir de courant (14) qui modifie un courant de commande du circuit amplificateur différentiel sur la base du signal de courant reçu de la section de conversion de signal pour commander ainsi le facteur d'amplification de la section d'amplification de signal,

dans lequel le circuit miroir de courant commande un courant de commande du circuit d'amplificateur différentiel, limitant le facteur d'amplification du circuit d'amplificateur différentiel de telle manière que le facteur d'amplification de la section d'amplification de signal diminue lorsque la tension du signal électrique augmente de façon à empêcher la sortie du circuit d'amplificateur différentiel de dépasser une valeur prédéterminée ;

un circuit de génération de tension de commande (7) qui extrait une valeur centrale d'une composante d'ondulation du signal électrique en tant que composante de changement du signal électrique et sort la composante de changement en tant que signal de sortie ; et

un circuit d'inversion de signal (8) qui inverse verticalement la forme d'onde du signal de sortie du circuit de génération de tension de commande et délivre le signal résultant,

dans lequel le signal de commande est sorti du circuit d'inversion de signal et entré dans la section de conversion de signal.

4. Dispositif de commande de moteur incluant une section de détection de courant qui détecte un courant d'induit d'un moteur à courant continu et émet une variation du courant sous la forme d'un signal de variation de tension, et le circuit d'élimination de bruit des revendications 1 ou 2, dans lequel le circuit d'élimination de bruit est agencé à un étage postérieur à la section de détection de courant et supprime le bruit en forme de pointe contenu dans le courant d'induit.

[FIG. 1]

[FIG. 2]

[FIG. 3]

Current detecting section

Voltage change signal

Noise component
Ripple component
Vi [peak]

Center value of ripple component

(Bias voltage)
Voff1
GND

21

Low-pass filter
fc1: Cutoff frequency

7

CV inverting circuit

$CV_0$

Vi' [peak]

(Bias voltage after CV conversion)
Voff1'
GND

Center value of ripple component fv(t)
(Waveform after CV conversion)

EP 3 700 082 B1

[FIG. 4]

[FIG. 5]

Suppress of
amplification at spike
noise portion

Remove

$\Delta$ V limit

$\Delta$ V +/−

(a)    Remove noise
without blunting original waveform

(b)

[FIG. 6]

[FIG. 7]

(Original waveform)

(Output waveform)

Spike noise

(a)

(b)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015211636 A
- EP 0405593 A2